(19) Europäisches Patentamt
European Patent Office
Office européen des brevets

(11) **EP 3 314 624 B1**

(12) **FASCICULE DE BREVET EUROPEEN**

(45) Date de publication et mention
de la délivrance du brevet:
**04.09.2019 Bulletin 2019/36**

(21) Numéro de dépôt: **16741359.0**

(22) Date de dépôt: **28.06.2016**

(51) Int Cl.:
*H01G 4/40* (2006.01)    *G06K 19/07* (2006.01)
*H01G 2/06* (2006.01)    *H01Q 7/00* (2006.01)
*H01L 27/13* (2006.01)    *H01Q 1/22* (2006.01)
*G06K 19/077* (2006.01)    *H05K 1/18* (2006.01)
*H05K 1/02* (2006.01)    *H05K 1/16* (2006.01)

(86) Numéro de dépôt international:
**PCT/FR2016/051594**

(87) Numéro de publication internationale:
**WO 2017/001761 (05.01.2017 Gazette 2017/01)**

(54) **MODULE ÉQUIPE D'UN CONDENSATEUR ET D'UNE ANTENNE, AVEC DISPOSITION D'ÉLECTRODE DE CONDENSATEUR AMÉLIORÉE**

MIT EINEM KONDENSATOR UND EINER ANTENNE AUSGESTATTETES MODUL MIT EINER VERBESSERTEN KONDENSATORELEKTRODENANORDNUNG

MODULE EQUIPPED WITH A CAPACITOR AND AN ANTENNA, WITH IMPROVED CAPACITOR ELECTRODE ARRANGEMENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.06.2015 FR 1556063**

(43) Date de publication de la demande:
**02.05.2018 Bulletin 2018/18**

(73) Titulaire: **IDEMIA France**
**92700 Colombes (FR)**

(72) Inventeur: **ALI, Ahmed**
**92700 Colombes (FR)**

(74) Mandataire: **Cabinet Beau de Loménie**
**158, rue de l'Université**
**75340 Paris Cedex 07 (FR)**

(56) Documents cités:
EP-A2- 0 737 935    EP-A2- 1 073 009
CA-A1- 2 221 315    FR-A1- 3 013 152
FR-A1- 3 013 483    US-A1- 2006 164 249
US-A1- 2014 292 611

**Description**

Arrière-plan de l'invention

L'invention se rapporte au domaine général des dispositifs électroniques munis d'antennes, par exemple des dispositifs de type RFID (« Radio Frequency identification » en langue anglaise) équipés d'une antenne de communication en champ proche.

EP0737935 divulgue un exemple d'un dispositif électronique muni d'antenne.

Les antennes de communication en champ proche de dispositifs de type RFID comportent une pluralité de spires formées par des pistes conductrices connectées à un microcircuit (couramment désigné par l'homme du métier par l'expression « RF chip »). Les dispositifs RFID conçus pour la communication en champ proche sont généralement configurés pour la communication en champ proche dans les bandes de fréquence comprises entre les basses fréquences (par exemple 125kHz) et les hautes fréquences (par exemple 30MHz). Les dispositifs RFID peuvent être basés sur la norme ISO 14 4443 ou encore la norme ISO 15693.

Pour obtenir un fonctionnement désiré, il est nécessaire de bien contrôler les paramètres géométriques de l'antenne de sorte que la fréquence de résonance associée soit bien ajustée. La fréquence de résonance est choisie pour correspondre à celle d'un lecteur externe. La fréquence de résonance est calculée en prenant en compte les paramètres électriques du microcircuit du dispositif.

L'antenne doit par ailleurs être configurée pour recevoir suffisamment de flux magnétique du champ magnétique du lecteur externe, et la surface effective comprise entre les spires de l'antenne est ajustée à cet effet. L'énergie reçue au moyen de ce flux magnétique est ensuite fournie au microcircuit, avec des pertes qui correspondent à la résistance de l'enroulement formant l'antenne.

L'élaboration d'un dispositif RFID conçu pour la communication en champ proche est donc faite sur la base d'un compromis entre la taille de l'antenne, les pertes ohmiques, et la fréquence de résonance. Ces paramètres sont choisis pour permettre la réception de suffisamment d'énergie et l'obtention de bonnes performances.

Il existe une demande forte pour des dispositifs RFID de petite taille. Dans de nombreuses applications comme par exemple les objets connectés, il est particulièrement critique de réduire les dimensions des dispositifs RFID, qui peuvent se présenter sous la forme d'un module incorporable à un objet. Par exemple, cet objet peut être un boîtier ou un bracelet dans lequel est incorporé directement le module.

Aussi, le module peut aussi être agencé entre deux couches de plastique pour former une carte de petit format qui sera par la suite intégrée dans un objet. On entend par petit format un format dont la surface est sensiblement équivalente ou inférieure au quart de la surface d'un format ID-1 (85,60mm*53,98mm) Selon la norme ISO7810.

Selon la technique antérieure, l'ajustement des paramètres électriques de l'antenne se fait, quelles que soient les contraintes géométriques de l'antenne, par compensation en connectant un condensateur à cette antenne pour augmenter la capacité du circuit résonnant comprenant l'antenne.

De nombreuses solutions d'intégration de condensateur ont été proposées. En particulier, il a été proposé d'utiliser des composants montés en surface ou des condensateurs planaires imprimés directement sur la surface d'une carte de circuit imprimé ou sur un substrat.

Les condensateurs planaires offrent un bon niveau de robustesse, leur valeur de capacité est calculable facilement, et cette valeur est bien contrôlable dans une chaîne de production. En effet, la valeur de capacité d'un condensateur planaire à plaques ou électrodes parallèles est égale à :

$$\frac{\epsilon_0 \epsilon_r A_C}{d},$$

en farad

Avec $\varepsilon_0$ la permittivité du vide, $\varepsilon_r$ la permittivité relative du matériau séparant les deux électrodes du condensateur, $A_C$ l'aire des électrodes en vis-à-vis l'une par rapport à l'autre, et d la distance séparant les électrodes.

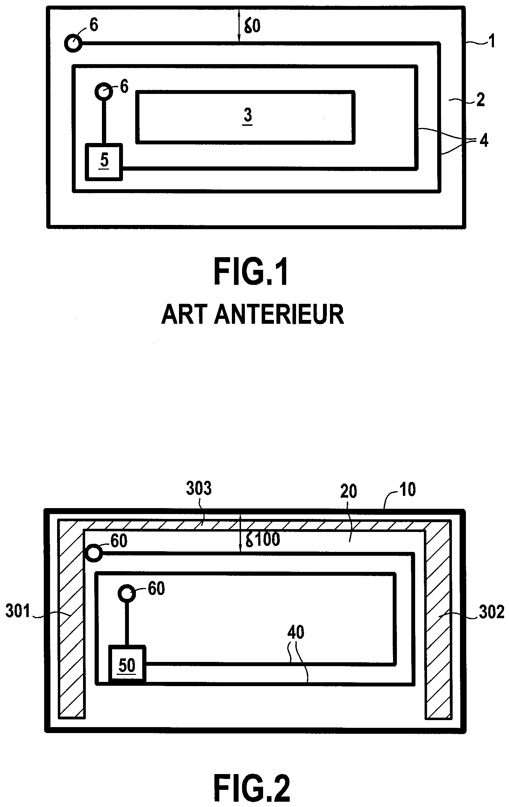

La figure 1 est une représentation en vue de dessus d'un module 1 selon la technique antérieur muni d'une antenne et d'un condensateur. Un tel module peut être intégré à un dispositif RFID. Le module 1 est ici formé sur une base 2, par exemple un substrat diélectrique. Une électrode 3 de condensateur et une antenne 4 ont été formées sur la base 2.

L'électrode de condensateur 3 est une électrode plane imprimée sur la base 2 en forme de rectangle disposé sensiblement au centre du module 1. L'autre électrode de ce condensateur est disposée sur la face de la base opposée à celle visible sur la figure 1.

L'antenne 4 comporte des spires imprimées autour de l'électrode 3. D'autres spires de la même antenne peuvent êtres imprimées sur la face opposée.

Par ailleurs, des liaisons traversantes conductrices 6 sont formées à travers la base, et l'antenne 4 et le condensateur 3 sont connectées à un microcircuit 5.

Cet agencement selon la technique antérieure dans lequel les spires d'antennes sont positionnées en périphérie, est utilisé pour augmenter la surface effective des spires de l'antenne.

Généralement, la permittivité relative pour les matériaux diélectriques utilisés pour les dispositifs RFID est comprise entre 3 et 9. La valeur de capacité des condensateurs dépend donc principalement du rapport entre l'aire des électrodes et la distance qui les sépare.

Du fait des limitations de taille imposées à ces dispositifs, il est délicat d'augmenter l'aire des électrodes.

Ce problème peut être résolu en choisissant un matériau diélectrique adapté et un substrat fin (les électrodes des condensateurs sont disposées sur des faces opposées).

Cela étant, les substrats les plus fins, par exemple ayant une épaisseur inférieure à 75 micromètres, sont compliqués à manipuler. Tel est le cas des substrats en polyéthylène téréphtalate (PET) ou en polyimide (Kapton) qui peuvent être de l'ordre de 40 micromètres. Les étapes de découpe ou de placement sont particulièrement difficiles à mettre en oeuvre sur de tels substrats.

Comme on peut le concevoir, les erreurs de placement peuvent conduire à une section d'une antenne lors d'une étape ultérieure de découpe, par exemple pour une antenne telle que celle illustrée sur la figure 1.

Sur la figure 1, l'erreur de placement pour une étape de découpe est limitée à une valeur $\delta 0$ qui est la plus petite distance entre la spire la plus grande (ou spire extérieure) et un bord du module. Cette valeur est en général trop faible et peu satisfaisante. Cette valeur $\delta 0$ correspond à la marge d'erreur autorisée concernant le placement du module lors d'une étape de découpe, et donc à une valeur maximale de tolérance de découpe. Actuellement, cette valeur est inférieure à 500 micromètres pour des substrats fins et mous en polyimide.

L'invention vise notamment à pallier ces inconvénients, et en particulier de réduire les pertes lors de la fabrication des dispositifs comprenant une antenne et un condensateur.

Objet et résumé de l'invention

La présente invention répond à ce besoin en proposant un module comprenant une base supportant un condensateur planaire, une antenne, et un microcircuit électriquement connectés entre eux pour former un circuit électrique résonant, le condensateur comportant sur une première face de la base une première électrode et une deuxième électrode disposée sur une deuxième face opposée à ladite première face en vis-à-vis de ladite première électrode, la deuxième électrode et la première électrode ayant sensiblement la même forme, voire la même forme.

Selon une caractéristique générale, chaque électrode présente au moins une première portion et une deuxième portion disposées de part et d'autre des spires de ladite antenne.

Ainsi, contrairement aux condensateurs de l'art antérieur, les électrodes du condensateur ne sont pas entièrement disposées à l'intérieur des spires de l'antenne, mais au moins de part et d'autre des spires formées sur la première face ou la deuxième face.

On peut noter que l'expression « de part et d'autre signifie que les électrodes sont disposées autour des spires, à l'extérieur des spires.

De ce fait, chaque portion est disposée entre les spires de l'antenne et un bord de la première face (ou de la deuxième face) du module. Il en découle que l'antenne est déplacée vers le centre du module et que la distance entre la spire la plus grande et le bord du module est augmentée au moins là où lesdites portions sont présentes, on réduit ainsi le risque de section de l'antenne.

Par ailleurs, les inventeurs ont observé que les électrodes, qui sont planaires et plus larges que des pistes d'antenne, améliorent la robustesse du module et facilitent sa manipulation (« pick and place » en langue anglaise) en rigidifiant les bords de la base.

Selon un mode particulier de réalisation, la première portion et la deuxième portion de la première électrode sont respectivement disposées au voisinage de bords opposés de ladite première face, la première et la deuxième portion de la deuxième électrode sont respectivement disposées au voisinage de bords opposées de ladite deuxième face, la première portion et la deuxième portion de chaque électrode étant reliées électriquement.

Par au voisinage de bords opposés, on entend qu'il n'y a pas d'autre élément du module entre ces portions d'électrodes et le bord. En outre, la distance qui sépare le bord des portions d'électrode peut être nulle ou inférieure à quelques dizaines de micromètres.

L'antenne et le condensateur occupent ainsi une surface plus grande que dans les solutions selon l'art antérieur puisque l'on utilise une surface qui n'était pas utilisée avant puisque l'antenne était le composant le plus extérieur et qu'il était nécessaire d'écarter l'antenne du bord.

Selon un mode particulier de réalisation, la première électrode est disposée à la périphérie de la première face, la deuxième électrode est disposée à la périphérie de la deuxième face, et les spires sont entourées par la première électrode et la deuxième électrode.

En d'autres termes, les deux portions mentionnées ci-avant font partie d'une électrode qui parcourt la périphérie du module pour entourer les spires de l'antenne de cette première face.

On peut noter que par entourer, on entend que dans un plan tel que celui de la première face, l'électrode entoure soit les spires de l'antenne qui sont sur la face, soit la projection de spires de l'antenne si celles sont dans un autre plan (par exemple enfouies).

On obtient ainsi une meilleure rigidification, dans toutes les directions.

Selon un mode particulier de réalisation, la première portion et la deuxième portion (qui peuvent faire partie d'une électrode disposée à la périphérie de la face) de la première électrode s'étendent respectivement jusqu'à et le long de bords opposés de ladite première face, et la première portion et la deuxième portion (qui peuvent également faire partie d'une électrode disposée à la périphérie de la face) de la deuxième électrode s'étendent respectivement jusqu'à et le long de bords opposés de ladite deuxième face.

En s'étendant le long d'au moins une partie des bords, on utilise une partie de surface qu'il était impossible d'occuper dans les solutions selon l'art antérieur pour lesquelles il était nécessaire d'espacer les spires de l'antenne du bord. On utilise ainsi une surface plus grande pour l'antenne et le condensateur pour un module ayant les mêmes dimensions.

Dans ce mode particulier de réalisation, le bord de la première face coïncide au moins pour une partie avec l'électrode. Une telle disposition peut être obtenue en formant une électrode dite avant découpe qui s'étend au-delà de l'endroit où l'on souhaite découper le module (les lignes de découpe). Ainsi, lors de la découpe, on découpe à la fois les bords de la base et ceux de l'électrode.

Selon un mode particulier de réalisation, pour chaque électrode la première portion est symétrique de la deuxième portion par rapport à un premier axe de symétrie passant par le centre du module.

En s'étendant jusqu'aux bords et en présentant une symétrie axiale, on comprend que lors de la découpe du module avec une électrode avant découpe étendue au-delà de lignes de découpes, un décalage dans une direction perpendiculaire au premier axe de symétrie n'influera pas sur la valeur de capacité du condensateur, puisqu'une surface d'électrode perdue d'un côté est récupérée de l'autre côté.

Selon un mode particulier de réalisation, chaque électrode s'étend jusqu'à et le long de tous les bords de la face sur laquelle elle est disposée (l'électrode étant disposée à la périphérie de ladite première face et lesdites spires sont entourées par ladite électrode), et chaque électrode présente une symétrie par rapport au premier axe de symétrie et par rapport à un deuxième axe passant par le centre du module et perpendiculaire audit premier axe.

Ce mode particulier de réalisation peut être obtenu en formant, préalablement à une découpe du module, une électrode avant découpe s'étendant dans toutes les directions au-delà de toutes les lignes de découpe du module. Ainsi, et parce que l'électrode est symétrique par rapport aux deux axes, une découpe avec un décalage dans n'importe quelle direction ne modifie pas la valeur de capacité du condensateur puisque la surface perdue est récupérée.

Selon un mode particulier de réalisation, le module est un module RFID configuré pour la communication en champ proche dans une bande de fréquence comprise entre les basses fréquences et les hautes fréquences.

Selon un mode particulier de réalisation, le module comporte au moins un orifice traversant la première électrode ou la deuxième électrode.

Par traversant, on entend que l'orifice traverse l'électrode jusqu'à déboucher sur la base.

Si une couche de matériau de protection, par exemple une couche en plastique est assemblée contre le module sur une face qui comporte l'antenne avec l'orifice, alors cette couche en plastique pourra être laminée sous une élévation de température et de pression et fluer par fusion dans l'orifice pour le remplir. Ceci améliore l'adhésion des couches de protection avec le reste du module, et l'on obtient un meilleur maintien.

Le ou les orifices peuvent être pris en compte pour déterminer la valeur de la capacité du condensateur.

Selon un mode particulier de réalisation, ledit au moins un orifice traverse la première électrode, la base, et la deuxième électrode.

On peut noter que le module peut comporter plusieurs orifices de ce type.

On améliore ainsi le maintien du module entre deux couches de matériau de protection qui vont remplir les orifices pour entrer en contact avec la base et avec elles-mêmes.

Selon un mode particulier de réalisation, le module comporte deux couches d'un matériau de protection disposées de part et d'autre de la base et recouvrant ladite antenne, ledit microcircuit, ladite première électrode, et ladite deuxième électrode,

le matériau de protection des couches de matériau de protection remplissant ledit au moins un orifice (qui peut traverser ou non la base, et une seule électrode ou les deux).

L'invention propose également un dispositif dans lequel est incorporé un module tel que défini ci-avant.

L'invention propose également un procédé de fabrication d'un module comprenant une base supportant un condensateur planaire, une antenne, et un microcircuit électriquement connectés entre eux pour former un circuit électrique résonant, le procédé comportant :

- une formation sur une première face de la base d'une électrode,
- une formation sur une deuxième face opposée à ladite première face d'une deuxième électrode en vis-à-vis de ladite première électrode, la deuxième électrode et la première électrode ayant sensiblement la même forme.

Selon une caractéristique générale du procédé, chaque électrode présente au moins une première portion et une deuxième portion disposées de part et d'autre des spires de ladite antenne.

Selon un mode particulier de mise en oeuvre, le procédé comprend une étape de découpe pour obtenir ledit module.

Selon un mode particulier de mise en oeuvre, la formation de ladite électrode comprend une formation d'une électrode avant découpe s'étendant au moins partiellement au-delà de lignes de découpe du module.

Selon un mode particulier de mise en oeuvre, l'électrode avant découpe s'étend au-delà des lignes de découpe du module d'une distance supérieure à une valeur maximale de tolérance de découpe.

Selon un mode particulier de mise en oeuvre, le procédé comprend une fabrication de plusieurs modules avant découpe sur une bande de modules avant découpe consécutifs, et des découpes des modules ayant découpe consécutifs de la bande pour obtenir des modules.

Ce procédé peut être adapté pour la fabrication de chacun des modes de réalisation d'un module tel que décrit ci-avant.

En particulier, l'électrode peut s'étendre au-delà de toutes les lignes de découpe du module dans un mode particulier de mise en oeuvre.

Selon un mode particulier de mise en oeuvre, on forme un orifice traversant la première électrode ou la deuxième électrode. La formation de cet orifice est préférentiellement mise en oeuvre avant une étape de découpe du module.

Selon un mode particulier de mise en oeuvre, ledit orifice traverse la première électrode, la deuxième électrode, et ladite base. La formation de cet orifice est préférentiellement mise en oeuvre avant une étape de découpe du module.

Selon un mode particulier de mise en oeuvre, on assemble deux couches d'un matériau de protection disposées de part et d'autre de la base et recouvrant ladite antenne, ledit microcircuit, ladite première électrode, et ladite deuxième électrode,

Le matériau de protection des couches de matériau de protection remplissant ledit au moins un orifice.

le matériau de protection des couches de matériau de protection remplissant ledit orifice.

L'assemblage des deux couches de matériau de protection est préférentiellement mis en oeuvre avant une étape de découpe de module, ce qui permet d'assembler des couches simultanément sur un grand nombre de modules.

## Brève description des dessins

D'autres caractéristiques et avantages de la présente invention ressortiront de la description faite ci-dessous, en référence aux dessins annexés qui en illustrent un exemple dépourvu de tout caractère limitatif.

Sur les figures :

- la figure 1, déjà décrite, est une représentation schématique d'un module selon l'art antérieur,
- la figure 2 est une représentation schématique d'un module selon l'invention,
- la figure 3 est une représentation schématique d'un module avant découpe,
- la figure 4 est une vue en coupe du module avant découpe de la figure 3,
- la figure 5 est une représentation schématique d'un dispositif équipé d'un module selon un exemple de l'invention,
- la figure 6 est une vue en coupe du module de la figure 5,

- la figure 7 est une vue en coupe d'un module comprenant un orifice et deux couches de matériau de protection, et
- la figure 8 est également une vue en coupe d'un module comprenant un orifice et deux couches de matériau de protection.

## Description détaillée de deux modes de réalisation

Nous allons maintenant décrire un module de type RFID équipé d'une antenne de communication en champ proche selon un mode de réalisation de l'invention.

Le module de cet exemple est un module selon la norme ISO 14 4443 ou ISO 15693, et il est configuré pour la communication en champ proche.

Sur la figure 2, on a représenté un module 10 qui comporte une base 20, par exemple une base en polyéthylène téréphtalate (PET) ayant une épaisseur de 75 micromètres ou une base en polyimide, par exemple en Kapton (marque déposée), ayant une épaisseur de moins de 40 micromètres. La figure 1 est une vue de dessus et l'on voit sur cette figure une première face de la base 20.

Une électrode de condensateur est formée sur cette première face de la base 20. Cette électrode comporte plusieurs portions 301, 302 et 303. L'autre électrode du condensateur est disposée sur la face opposée et en vis-à-vis de l'électrode visible sur la première face, et cette électrode a la même forme que l'électrode de la première face.

La formation des électrodes peut être réalisée par sérigraphie, ce qui permet d'imprimer une épaisseur de l'ordre de 8 micromètres, ou encore par gravure, ce qui permet de laisser subsister une épaisseur allant de 12 à 30 micromètres.

Le module 10 est également équipé sur la première face d'une antenne comportant des spires 40, d'un microcircuit 50 et de liaisons traversantes 60 allant jusqu'à une face sous-jacente, la face opposée à la première face.

Dans cet exemple, les portions 301 et 302 sont disposées de part et d'autres des spires 40 de l'antenne. La portion 303 relie ces deux premières portions. Les deux portions 301 et 302, qui sont plus larges que des pistes d'antenne, permettent de rigidifier le module 10 de cette figure. Cette rigidification permet de faciliter la manipulation du module.

En outre, le placement des portions d'électrode 301 et 302 implique que l'antenne est décalée vers le centre du module pour respecter les règles d'espacement entre les éléments conducteurs formés sur une même face. De ce fait, la distance 5100 , qui est la plus petite distance entre la spire extérieure et un bord de la première face est supérieure à la distance $\delta_0$ décrite en référence à la figure 1.

On va maintenant décrire un autre mode de réalisation de l'invention dans lequel l'électrode entoure les spires de l'antenne et dans lequel la découpe du module est faite après qu'une électrode avant découpe s'étendant au-delà de bords de découpe ait été formée.

L'exemple illustré sur ces figures vise également un module RFID configuré pour la communication en champ proche.

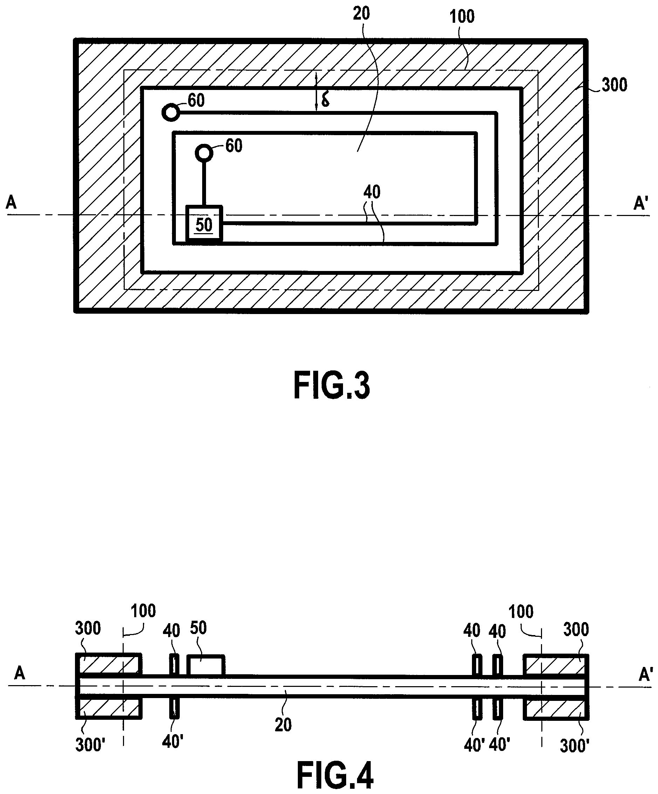

Sur les figures 3 à 6, les références identiques à celles utilisées sur la figure 2 visent des éléments identiques, sauf s'il est précisé autrement.

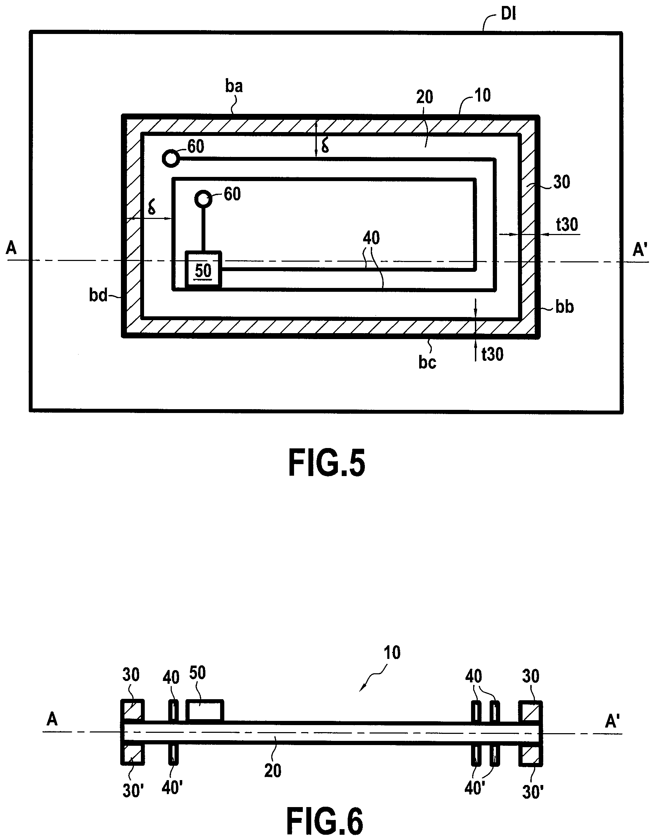

La figure 3 illustre un module avant découpe préalablement à une étape de découpe permettant d'obtenir un module qui sera décrit en référence aux figures 5 et 6.

Le module avant découpe de cette figure est formé sur un substrat plus étendu que la base 20 du module que l'on souhaite former. Sur ce substrat, on a également formé une électrode avant découpe 300 qui recouvre une surface plus grande que la surface occupée par l'électrode du module final.

Le module est obtenu en découpant à travers l'électrode initiale 300 et le substrat la forme et la position souhaitées pour le module. La position et la forme souhaitée sont représentée par des lignes de découpe 100.

Comme on peut le voir sur la figure, l'électrode avant découpe 300 s'étend bien au-delà des lignes de découpe 100, et ici, l'électrode obtenue après découpe entourera les spires de l'antenne 40 et elle sera disposée à la périphérie du module. L'électrode qui sera obtenue est par ailleurs symétrique par rapport à un axe vertical et un axe horizontal qui passeront par le centre du module.

La découpe peut être mise en oeuvre à l'emporte-pièce (« punching » en langue anglaise), et c'est lors de cette étape qu'un risque de section d'une spire de l'antenne peut apparaître.

Cela étant, ici, les spires de l'antenne sont décalées vers le centre par rapport aux solutions selon l'art antérieur et la distance δ qui est la plus petite distance entre la spire extérieure de l'antenne et les lignes de découpe est plus grande que la distance δ0 décrite en référence à la figure 1.

Ici, un décalage des lignes de découpe 100 inférieur à la distance δ, horizontal et/ou vertical (sur la figure), ne peut pas conduire à l'obtention d'un module défaillant, puisque l'antenne n'est pas sectionnée et parce que la valeur de capacité du condensateur est conservée puisque l'électrode avant découpe s'étend au-delà des lignes de découpe et l'électrode présente une symétrie horizontale et une symétrie verticale sur la figure.

Un tel décalage fait perdre une surface d'électrode (et donc de condensateur) en un endroit, mais cette surface est récupérée à un autre endroit.

On peut noter que l'électrode avant découpe s'étend vers l'extérieur du module au moins de la distance δ depuis tout point des lignes de découpe 100 pour qu'un décalage inférieur ou égal à δ soit acceptable.

Dans cet exemple, δ est donc bien une marge d'erreur acceptable concernant la découpe du module.

On peut noter que la surface occupée par l'électrode avant découpe 200 augmente la rigidité à la fois du module avant découpe mais également d'une bande comportant plusieurs modules initiaux attachés les uns aux autres préalablement à leur découpe. La manipulation d'une telle bande est ainsi facilitée.

La figure 4 est une vue en coupe du module avant découpe de la figure 3 passant par l'axe A-A' représenté sur la figure 3.

Sur cette figure, on a représenté la base 20 qui n'a pas encore été découpée, l'électrode avant découpe 300, les spires de l'antenne 40, et le microcircuit 50, ces derniers éléments étant disposés sur la première face de la base, la face supérieure sur la figure.

Sur la deuxième face, c'est-à-dire la face inférieure sur la figure, on a représenté en regard de l'électrode avant découpe 300 une autre électrode avant découpe 300', ainsi que des spires d'antenne 40' appartenant à la même antenne que les spires 40.

Les électrodes avant découpe 300 et 300' sont disposées en vis-à-vis et elles ont la même forme.

Après découpe selon les lignes de découpe 100 représentées aux figures 3 et 4, on obtient un module 10 représenté à la figure 5.

Sur cette figure 5, on a représenté un module 10 incorporé à un dispositif DI, par exemple par surmoulage. Le dispositif DI peut être un objet connecté tel qu'un bracelet.

Le module 10 comporte une base 20 et une électrode de condensateur 30 disposée à la périphérie de la première face. Ici, l'électrode s'étend jusqu'à et le long de tous les bords ba, bb, bc et bd de la première face puisque la découpe a été faite à travers l'électrode avant découpe 300. Ici, l'électrode 30 a une largeur t30 mesurée à partir du bord qui est la même en tout point autour du module.

La réduction des pertes lors de la fabrication du module 10 est liée à la distance δ séparant la spire extérieure de l'antenne du bord de la face de la base 20 (la plus petite distance séparant la spire extérieure et un bord). Cette distance δ est supérieure à la distance et correspondant à un module selon l'art antérieur. Ceci est dû au décalage des spires de l'antenne vers le centre du module.

A titre d'exemple, la distance δ peut être de l'ordre de plus ou moins 500 micromètres voire plus ou moins 1 millimètre de chaque côté.

Un autre avantage de cette disposition d'électrode est l'amélioration de la rigidité du module 10. Ceci facilite la manipulation du module.

La figure 6 est une vue en coupe du module 10 passant par l'axe A-A' représenté sur la figure 5.

Sur cette figure, on a représenté le module 10, la base 20, l'électrode 30, les spires de l'antenne 40 et le microcircuit 50, ces derniers éléments étant disposés sur la première face de la base, la face supérieure sur la figure.

Sur la deuxième face, c'est-à-dire la face inférieure sur la figure, on a représenté en regard de l'électrode 30 une autre électrode 30', ainsi que des spires d'antenne 40' appartenant à la même antenne que les spires 40.

L'invention permet d'obtenir des modules selon la norme ISO 14 4443 ou ISO 15693 munis d'une antenne et d'un condensateur sur des substrats particulièrement fins puisqu'ils sont rigidifiés. A titre indicatif, pour un substrat en polyimide de type Kapton (marque déposée) ayant une permittivité relative égale à 3,4, on peut obtenir des condensateurs ayant une capacité de 60 picofarads avec une géométrie telle que celle illustrée sur la figure 2. Une telle valeur de capacité peut être obtenue pour un module ayant une surface de 5 millimètres par 50 millimètres, et des substrats ayant une épaisseur de 75 micromètres (l'aire des électrodes est alors de 150 millimètres carrés), de 50 micromètres (l'aire des électrodes est alors de 100 millimètres carrés), ou encore de 25 micromètres (l'aire des électrodes est alors de 50 millimètres carrés).

On peut noter que dans cet exemple, l'aire est le double de l'épaisseur de la base.

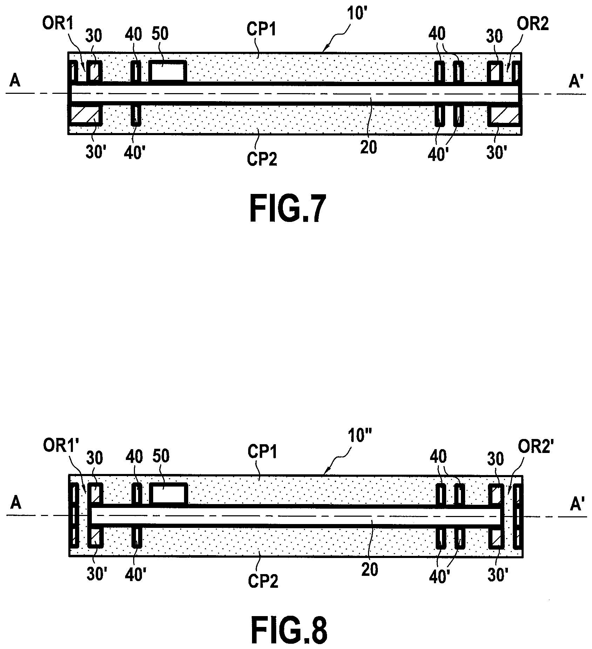

Sur la figure 7, on a représenté un module 10' selon une variante de l'invention. Les éléments qui portent les mêmes références que ceux décrits en référence à la figure 6 sont analogues.

Dans cette variante, préalablement à la découpe du module, on a formé deux orifices OR1 et OR2 qui traversent la première électrode 30. Ces orifices peuvent être circulaires et avoir un diamètre compris entre 0,5 millimètre et 2 millimètres.

Aussi, préalablement à la découpe du module, on a assemblé deux couches de matériau de protection CP1 et CP2 (par exemple en plastique) de part et d'autre du module.

Les couches de matériau de protection sont assemblées avec le reste du module par laminage sous une élévation de pression et de température. Ainsi, le matériau de protection va fluer et remplir l'orifice où il pourra se lier par fusion au matériau de la base 20. Ceci permet d'obtenir un bon maintien du module entre les deux bases.

Sur la figure 8, on a représenté un module 10" selon une autre variante dans laquelle on a formé deux orifices OR1' et OR2' qui traversent les électrodes 30 et 30' ainsi que la base. Deux couches de matériau de protection CP1 et CP2 ont également été assemblées.

Les couches de matériau de protection CP1 et CP2 remplissent les deux orifices et ont pu fusionner ensemble et avec la base 20, ce qui permet d'obtenir un maintien encore meilleur que celui du module 10' décrit en référence à la figure 7.

**Revendications**

**1.** Module comprenant une base (20) supportant un condensateur planaire, une antenne, et un microcircuit électriquement connectés entre eux pour former un circuit électrique résonant, le condensateur comportant sur une première face de la base une première électrode (30, 301, 302, 303) et une deuxième électrode (30') disposée sur une deuxième face opposée à ladite première face en vis-à-vis de ladite première électrode, la deuxième électrode et la première électrode ayant sensiblement la même forme, **caractérisé en ce que** chaque électrode présente au moins une première portion et une deuxième portion disposées de part et d'autre des spires (40) de ladite antenne.

**2.** Module selon la revendication 1, dans lequel la première portion et la deuxième portion de la première électrode sont respectivement disposées au voisinage de bords opposés de ladite première face, la première et la deuxième portion de la deuxième électrode sont respectivement disposées au voisinage de bords opposées de ladite deuxième face, la première portion et la deuxième portion de chaque électrode étant reliées électriquement.

**3.** Module selon la revendication 1 ou 2, dans lequel la première électrode (30) est disposée à la périphérie de ladite première face, la deuxième électrode est disposée à la périphérie de ladite deuxième face, et lesdites spires sont entourées par la première électrode et la deuxième électrode.

**4.** Module selon la revendication 2 ou 3, dans lequel la première portion et la deuxième portion de la première électrode s'étendent respectivement jusqu'à et le long de bords opposés de ladite première face, et la première portion et la deuxième portion de la deuxième électrode s'étendent respectivement jusqu'à et le long de bords opposés de ladite deuxième face.

**5.** Module selon la revendication 4, dans lequel pour chaque électrode la première portion est symétrique de la deuxième portion par rapport à un premier axe de symétrie passant par le centre du module.

**6.** Module selon la combinaison des revendications 3 à 5, dans lequel chaque électrode s'étend jusqu'à et le long de tous les bords de la face sur laquelle elle est disposée, et chaque électrode présente une symétrie par rapport au premier axe de symétrie et par rapport à un deuxième axe passant par le centre du module et perpendiculaire audit premier axe.

**7.** Module selon l'une quelconque des revendications 1 à 6, dans lequel le module est un module RFID configuré pour la communication en champ proche dans une bande de fréquence comprise entre les basses fréquences et les hautes fréquences.

8. Module selon l'une quelconque des revendications 1 à 7, comportant au moins un orifice (OR1, OR2, OR1', OR2') traversant la première électrode ou la deuxième électrode.

9. Module selon la revendication 8, dans lequel ledit au moins un orifice (OR1', OR2') traverse la première électrode, la base, et la deuxième électrode.

10. Module selon la revendication 8 ou 9, comprenant deux couches d'un matériau de protection (CP1, CP2) disposées de part et d'autre de la base et recouvrant ladite antenne, ledit microcircuit, ladite première électrode, et ladite deuxième électrode, le matériau de protection des couches de matériau de protection remplissant ledit au moins un orifice.

11. Dispositif dans lequel est incorporé un module (10) selon l'une quelconque des revendications 1 à 10.

12. Procédé de fabrication d'un module comprenant une base (20) supportant un condensateur planaire, une antenne, et un microcircuit électriquement connectés entre eux pour former un circuit électrique résonant, le procédé comportant :

    - une formation sur une première face de la base d'une électrode (30, 301, 302, 303),
    - une formation sur une deuxième face opposée à ladite première face d'une deuxième électrode en vis-à-vis de ladite première électrode, la deuxième électrode et la première électrode ayant sensiblement la même forme,

    **caractérisé en ce que** chaque électrode présente au moins une première portion et une deuxième portion disposées de part et d'autre des spires (40) de ladite antenne.

13. Procédé selon la revendication 12, comprenant une étape de découpe pour obtenir ledit module.

14. Procédé selon la revendication 13, dans lequel la formation de ladite électrode comprend une formation d'une électrode avant découpe (300) s'étendant au moins partiellement au-delà de lignes de découpe (100) du module.

15. Procédé selon la revendication 14, dans lequel l'électrode avant découpe s'étend au-delà des lignes de découpe du module d'une distance supérieure à une valeur maximale de tolérance de découpe.

**Patentansprüche**

1. Modul, umfassend eine Basis (20), die einen planaren Kondensator, eine Antenne und eine Mikroschaltung trägt, die elektrisch miteinander verbunden sind, um einen Resonanzstromkreis zu bilden, wobei der Kondensator auf einer ersten Fläche der Basis eine erste Elektrode (30, 301, 302, 303) und eine zweite Elektrode (30') aufweist, die auf einer zweiten Fläche angeordnet ist, die der ersten Fläche gegenüberliegt, die der ersten Elektrode gegenüberliegend angeordnet ist, wobei die zweite Elektrode und die erste Elektrode im Wesentlichen die gleiche Form aufweisen, **dadurch gekennzeichnet, dass** jede Elektrode mindestens einen ersten Abschnitt und einen zweiten Abschnitt aufweist, die zu beiden Seiten der Windungen (40) der Antenne angeordnet sind.

2. Modul nach Anspruch 1, wobei der erste Abschnitt und der zweite Abschnitt der ersten Elektrode jeweils in der Nähe von gegenüberliegenden Kanten der ersten Fläche angeordnet sind, der erste und der zweite Abschnitt der zweiten Elektrode jeweils in der Nähe von gegenüberliegenden Kanten der zweiten Fläche angeordnet sind, wobei der erste Abschnitt und der zweite Abschnitt von jeder Elektrode elektrisch verbunden sind.

3. Modul nach Anspruch 1 oder 2, wobei die erste Elektrode (30) an der Peripherie der ersten Fläche angeordnet ist, die zweite Elektrode an der Peripherie der zweiten Fläche angeordnet ist und die Windungen von der ersten Elektrode und der zweiten Elektrode umgeben sind.

4. Modul nach Anspruch 2 oder 3, wobei sich der erste Abschnitt und der zweite Abschnitt der ersten Elektrode jeweils bis zu und entlang von gegenüberliegenden Kanten der ersten Fläche erstrecken und sich der erste Abschnitt und der zweite Abschnitt der zweiten Elektrode jeweils bis zu und entlang von gegenüberliegenden Kanten der zweiten Fläche erstrecken.

5. Modul nach Anspruch 4, wobei der erste Abschnitt für jede Elektrode symmetrisch zu dem zweiten Abschnitt gegenüber einer ersten Symmetrieachse ist, die durch die Mitte des Moduls verläuft.

6. Modul nach der Kombination der Ansprüche 3 bis 5, wobei sich jede Elektrode bis zu und entlang von allen Kannten der Fläche erstreckt, auf der sie angeordnet ist, und jede Elektrode eine Symmetrie gegenüber der ersten Symmetrieachse und gegenüber einer zweiten Achse aufweist, die durch die Mitte des Moduls verläuft und zu der ersten Achse senkrecht ist.

7. Modul nach einem der Ansprüche 1 bis 6, wobei das Modul ein RFID-Modul ist, das für die Nahfeldkommunikation in einem Frequenzbereich zwischen den niedrigen Frequenzen und den hohen Frequenzen konfiguriert ist.

**8.** Modul nach einem der Ansprüche 1 bis 7, umfassend mindestens eine Öffnung (OR1, OR2, OR1', OR2'), die die erste Elektrode oder die zweite Elektrode durchquert.

**9.** Modul nach Anspruch 8, wobei die mindestens eine Öffnung (OR1', OR2') die erste Elektrode, die Basis und die zweite Elektrode durchquert.

**10.** Modul nach Anspruch 8 oder 9, umfassend zwei Schichten eines Schutzmaterials (CP1, CP2), die auf beiden Seiten der Basis angeordnet sind und die Antenne, die Mikroschaltung, die erste Elektrode und die zweite Elektrode bedecken, wobei das Schutzmaterial der Schichten von Schutzmaterial die mindestens eine Öffnung füllt.

**11.** Vorrichtung, in die ein Modul (10) nach einem der Ansprüche 1 bis 10 eingebaut ist.

**12.** Verfahren zur Herstellung eines Moduls, umfassend eine Basis (20), die einen planaren Kondensator, eine Antenne und eine Mikroschaltung trägt, die elektrisch miteinander verbunden sind, um einen Resonanzstromkreis zu bilden, wobei das Verfahren aufweist:

- ein Bilden einer Elektrode (30, 301, 302, 303) auf einer ersten Fläche der Basis,
- ein Bilden auf einer zweiten Fläche, die der ersten Fläche gegenüberliegt, einer zweiten Elektrode, die der ersten Elektrode gegenüberliegend angeordnet ist, wobei die zweite Elektrode und die erste Elektrode im Wesentlichen die gleiche Form aufweisen,

**dadurch gekennzeichnet, dass** jede Elektrode mindestens einen ersten Abschnitt und einen zweiten Abschnitt aufweist, die zu beiden Seiten der Windungen (40) der Antenne angeordnet sind.

**13.** Verfahren nach Anspruch 12, umfassend einen Schritt des Schneidens, um das Modul zu erhalten.

**14.** Verfahren nach Anspruch 13, wobei das Bilden der Elektrode ein Bilden einer Elektrode vor dem Schneiden (300) aufweist, die sich mindestens teilweise über Schneidelinien (100) des Moduls hinaus erstreckt.

**15.** Verfahren nach Anspruch 14, wobei sich die Elektrode vor dem Schneiden über Schneidelinien des Moduls hinaus um einen Abstand erstreckt, der größer als ein maximaler Schneidetoleranzwert ist.

**Claims**

**1.** A module comprising a base (20) supporting a planar capacitor, an antenna, and a microcircuit electrically connected to each other to form a resonant electrical circuit, the capacitor including on a first face of the base a first electrode (30, 301, 302, 303) and a second electrode (30') disposed on a second face opposite to said first face facing said first electrode, the second electrode and the first electrode having substantially the same shape, **characterized in that** each electrode has at least a first portion and a second portion disposed on either side of the turns (40) of said antenna.

**2.** The module according to claim 1, wherein the first portion and the second portion of the first electrode are respectively disposed in the vicinity of opposite edges of said first face, the first and the second portion of the second electrode are respectively disposed in the vicinity of opposite edges of said second face, the first portion and the second portion of each electrode being electrically connected.

**3.** The module according to claim 1 or 2, wherein the first electrode (30) is disposed on the periphery of said first face, the second electrode is disposed on the periphery of said second face, and said turns are surrounded by the first electrode and the second electrode.

**4.** The module according to claim 2 or 3, wherein the first portion and the second portion of the first electrode extend respectively to and along opposite edges of said first face, and the first portion and the second portion of the second electrode extend respectively to and along opposite edges of said second face.

**5.** The module according to claim 4, wherein for each electrode the first portion is symmetrical with the second portion with respect to a first axis of symmetry passing through the center of the module.

**6.** The module according to the combination of claims 3 to 5, wherein each electrode extends to and along all the edges of the face on which it is disposed, and each electrode has symmetry with respect to the first axis of symmetry and with respect to a second axis passing through the center of the module and perpendicular to said first axis.

**7.** The module according to any one of claims 1 to 6, wherein the module is an RFID module configured for near-field communication in a frequency band comprised between the low frequencies and the high frequencies.

8. The module according to any one of claims 1 to 7, including at least one opening (OR1, OR2, OR1', OR2') passing through the first electrode or the second electrode.

9. The module according to claim 8, wherein said at least one opening (OR1', OR2') passes through the first electrode, the base, and the second electrode.

10. The module according to claim 8 or 9, comprising two layers of a protective material (CP1, CP2) disposed on either side of the base and covering said antenna, said microcircuit, said first electrode, and said second electrode,
the protective material of the layers of protective material filling said at least one opening.

11. A device in which is incorporated a module (10) according to any one of claims 1 to 10.

12. A method of manufacturing a module comprising a base (20) supporting a planar capacitor, an antenna, and a microcircuit electrically connected to each other to form a resonant electrical circuit, the method including:

   - formation, on a first face of the base, of an electrode (30, 301, 302, 303),
   - formation, on a second face opposite to said first face, of a second electrode facing said first electrode, the second electrode and the first electrode having substantially the same shape,

   **characterized in that** each electrode has at least a first portion and a second portion disposed on either side of the turns (40) of said antenna.

13. The method according to claim 12, comprising a cutting step to obtain said module.

14. The method according to claim 13, wherein the formation of said electrode comprises the formation of a pre-cutting electrode (300) extending at least partially beyond cutting lines (100) of the module.

15. The method according to claim 14, wherein the pre-cutting electrode extends beyond the cutting lines of the module by a distance greater than a maximum cutting tolerance value.

## FIG.1

### ART ANTERIEUR

## FIG.2

FIG.3

FIG.4

**FIG.5**

**FIG.6**

**FIG.7**

**FIG.8**

**EP 3 314 624 B1**

## RÉFÉRENCES CITÉES DANS LA DESCRIPTION

**Documents brevets cités dans la description**

- EP 0737935 A